# EUROPEAN PATENT APPLICATION

(11) **EP 2 846 461 A1**
(43) Date of publication of application: **11.03.2015**
(21) Application number: 13360028.8
(22) Date of filing: 10.09.2013
(51) Int. Cl.: H03F 1/32, H03F 3/24

(54) **A method for improving amplifier digital pre-distortion estimation performance and radio transmitter**

(71) Applicant: ALCATEL LUCENT, 92100 Boulogne-Billancourt (FR)
(72) Inventor: Patterson, Geoffrey, Swindon, Wiltshire SN5 7YT (GB)
(74) Representative: Greenwood, Matthew David

(57) **Abstract**

There is provided a method for improving amplifier digital pre-distortion estimation performance. The method comprises the steps of selecting a peak of an input signal to be amplified having a signal level that is below an upper threshold signal level; expanding the selected peak to the upper threshold signal level; and performing amplifier pre-distortion estimation based on the expanded signal of the selected peak.

## Description

### FIELD OF THE INVENTION

The present invention relates to a method for increasing amplifier digital pre-distortion estimation performance and a radio digital transmitter.

### BACKGROUND OF THE INVENTION

Digital pre distortion (DPD) is a technique used to improve the linearity of radio transmitter amplifiers. DPD circuitry models the gain and phase characteristics of the amplifier and when combined with the amplifier produces an overall system that is more linear and reduces the amplifier's distortion.

When estimating the DPD correction functions used to correct non-linear amplifiers, errors can be introduced into the correction function if the signals captured do not include samples that hit the maximum peak power supported by the system. In the worst cases these can cause hardware damage to the amplifier.

A number of methods have been proposed to mitigate this problem. Firstly, it has been proposed to merge DPD functions from different powers. Secondly, it has been proposed to select the best samples in order to generate estimates. Thirdly, it has been proposed to use a coefficient estimation method and apparatus, the so called inflation and illumination method.

However, all of these methods have a number of drawbacks. For example, the effectiveness of merging DPD functions is dependent on the quality of the DPD functions that are being merged. Similarly, the effectiveness of selecting the best samples to use in generating estimates is dependent on being able to select a high quality sample from the pool of samples.

Further, although the inflation and illumination method ensures that DPD has visibility of the highest peaks supported by the amplifier, this method is not desirable as it is complicated to configure, network operator (customer) visible and can reduce cell traffic load.

It is therefore desirable improve the quality of DPD estimates generated.

### SUMMARY OF THE INVENTION

According to a first aspect of the invention, there is provided a method for improving amplifier digital pre-distortion estimation performance, comprising the steps of:
selecting a peak of an input signal to be amplified having a signal level that is below an upper threshold signal level; expanding the selected peak to the upper threshold signal level; and performing amplifier pre-distortion estimation based on the expanded signal of the selected peak.

The simplifier pre-distortion estimation may be based on a capture of the input signal including the expanded peak.

The step of selecting a peak of an input signal to be amplified may comprise: determining that a peak in the input signal exceeds a lower threshold signal level.

The step of selecting a peak of an input signal to be amplified may comprise: monitoring the input signal for a period of time.

The step of selecting a peak of an input signal to be amplified may comprise: selecting the first peak in the input signal in the monitored period of time that exceeds the lower threshold value.

The step of selecting a peak of an input signal to be amplified may comprise: reducing the lower threshold value if no peak in the input signal exceeds a lower threshold signal level in the monitored period of time.

The step of selecting a peak of an input signal to be amplified may comprise: monitoring the input signal for a further period of time; and determining that a peak in the input signal exceeds the reduced lower threshold signal level.

The step of expanding the signal of the selected peak to the upper threshold signal level may comprise: generating a peak expansion signal based on the difference between the signal level of the selected peak and the upper threshold signal level.

The step of expanding the signal of the selected peak to the upper threshold signal level may comprise: filtering the peak expansion signal with a digital filter having a pass band matching the mask of the carrier of the signal to be amplified.

The step of expanding the signal of the selected peak to the upper threshold signal level may comprise: delaying the input signal while the steps of selecting a peak of an input signal to be amplified having a signal level that is below an upper threshold signal level, expanding the selected peak to the upper threshold signal level selecting and filtering the peak expansion signal are performed.

The step of expanding the signal of the selected peak to the upper threshold signal level may comprise: combining the filtered peak expansion signal with the delayed input signal to generate an expanded input signal for use in the amplifier pre-distortion estimation.

The upper threshold signal level may be the maximum peak power supported by the amplifier.

The amplifier pre-distortion estimation may be performed in real time.

The method may be performed at the same sample rate as the DPD sample rate.

The steps of selecting a peak of an input signal to be amplified and expanding the selected peak may comprise a crest factor enhancement method.

A peak of an input signal to be amplified may be selected and expanded periodically during each time period taken to perform amplifier digital pre-distortion estimation.

The method may be implemented in custom hardware, such as a field-programmable gate array (FPGA) or an application-specific integrated circuit (ASIC). The method may be implemented in software.

According to a second aspect of the present invention, there is provided a radio digital transmitter having an amplifier operable to amplify an input signal, comprising: a crest factor expansion unit operable to select a peak of an input signal to be amplified having a signal level that is below an upper threshold signal level, and expand the selected peak to the upper threshold signal level; and an amplifier digital pre-distortion estimation unit operable to perform amplifier pre-distortion estimation for the amplifier based on the expanded signal of the selected peak from the crest factor expansion unit.

According to a third aspect of the invention, there is provided a computer program product operable when executed on a computer to perform the method of the above first aspect.

Further particular and preferred aspects of the invention are set out in the accompanying independent and dependent claims.

### BRIEF DESCRIPTION OF THE DRAWINGS

Some embodiments of the apparatus and/or methods in accordance with embodiment of the present invention are now described, by way of example only, with reference to the accompanying drawings, in which:
Figure 1 schematically shows crest factor enhancement according to an embodiment; and
Figure 2 schematically shows a radio digital transmitter chain including crest factor enhancement.

### DESCRIPTION OF EMBODIMENTS

It is known to use Crest Factor Reduction (CFR), sometimes referred to as peak limiting, to reduce the peak power requirements for amplifiers in communications systems. For example, if a signal has a high peak to average power ratio, the peaks can be reduced while introducing Error Vector Magnitude (EVM). As long as the EVM is still within the requirements of the standard, the introduction of EVM does not cause a problem. CFR is a method of reducing the peak power requirements of the amplifier and hence reducing cost. It is also common in these systems that use CFR to use digital pre distortion (DPD) to correct none linear functions in the amplifier.

In DPD, a set of the digital transmit data and sampled data at the output of the amplifier is used to generate a digital correction function that is the inverse of the distortion in the amplifier. The generation of this correction function is called DPD estimation. DPD estimation works best where the captured signal fed to the estimator contains some samples that are at the maximum power supported by the amplifier. However, these cannot be guaranteed to occur when the system is running in normal operation. If signals do not hit the max power of the amplifier, errors can be introduced to the quality of the DPD estimation. These errors can cause the generation of DPD correction functions that can damage the amplifier hardware, which has major cost implications and can also degrade system performance to the extent that regulatory specifications are not met.

In order to ensure that samples always hit the maximum power supported by the amplifier, thereby ensuring the accuracy of the DPD estimation, it is proposed to use the opposite function to CFR, in order to enhance the peaks in a signal, rather than reduce the peaks of a signal as in CFR. This technique of enhancing peaks may be referred to as Crest Factor Enhancement (CFE). By using CFE, it can be ensured that data fed to the DPD estimator always has samples hitting the maximum power supported by the amplifier.

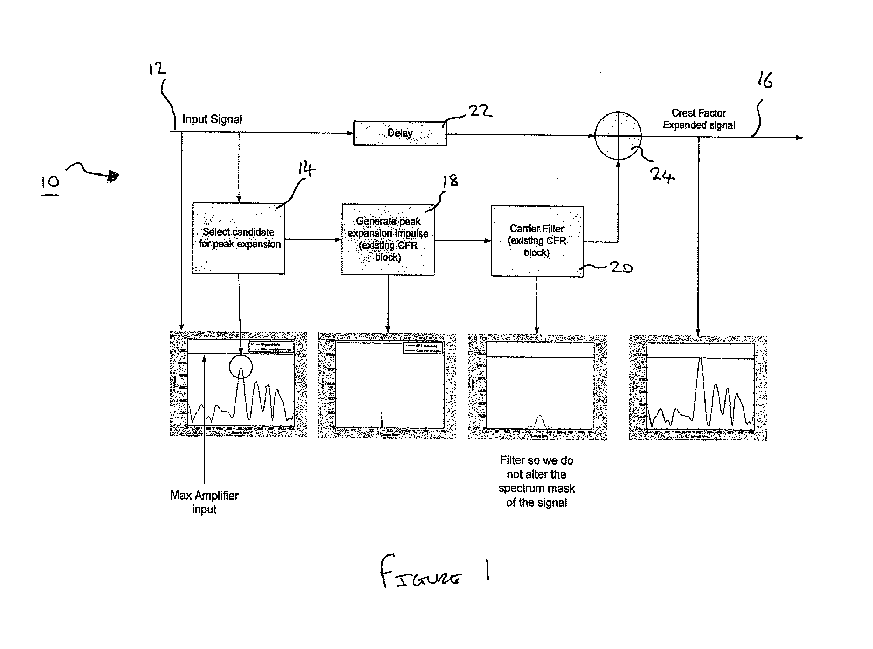

Figure 1 schematically shows CFE method 10 for a CFE unit according to an embodiment. As can be seen in Figure 1, when a DPD estimation is required, the CFE unit monitors the input signal 12 to determine if any peaks are seen hitting the maximum power supported by the amplifier. If a peak is determined to hit the maximum power supported by the amplifier, the sample of the input signal including this peak is provided for DPD estimation.

If no peak is determined to reach the maximum power supported by the amplifier, the CFE unit is operable to select 14 a candidate peak from the input signal 12 for peak expansion. There a many factors that the CFE unit may take into account in order to select a candidate peak from the input signal 12 for peak expansion.

For example, the CFE unit may select a peak by determining if any of the peaks in the input signal exceeds a threshold signal level. In other words, the CFE unit may select the peak in the input signal that is closest to the maximum power supported by the amplifier. The CFE unit may monitor the input signal from a period of time, which may be a predetermined period of time, or over a particular number of samples, and may select the peak in the input signal that is closest to the maximum power supported by the amplifier in the period of time. It is important to note that the input signal is a streaming signal and so it is not possible to go back in time to select an old peak. A small delay can be used to give a window in which to monitor, but this is finite. Alternatively, the CFE unit may select the first peak in the input signal in the monitored period of time that exceeds a threshold value. For example, the CFE unit may monitor for say 500 samples at say 4ns per sample, giving a monitoring period of 500 × 4nS = 2µS. Also, the CFE unit may check for a peak in the input signal for peak expansion every 1 ms to 10ms.

If over a period of time, no peak exceeds the threshold valve, the CFE unit may reduce the threshold value in order to select the peak of the input signal closest to the maximum power supported by the amplifier. This process may be iterative and the CFE unit may continue to keep reducing the threshold level until a peak of the input signal is selected for peak expansion.

Once a peak of the input signal has been selected for peak expansion, the CFE unit is operable to generate a crest factor expanded signal 16 in which the peak selected by the CFE unit has been enhanced to the maximum power supported by the amplifier.

The step of expanding the signal level of the selected peak to the maximum power supported by the amplifier may comprise generating a peak expansion impulse 18 and by filtering 20 the peak expansion signal with a digital filter having a pass band matching the mask of the carrier of the signal to be amplified. In other words, an impulse of the required magnitude is added to the peak in order that the peak is expanded to the maximum power of the amplifier, and the expanded peak is filtered.

It should be noted that the step of generating a peak expansion impulse and filtering the peak expansion signal may be performed by existing blocks in present in CFR circuitry, but by inverting the impulse generation for expansion of the peak, rather than reduction. However, it should be appreciated that the step of selecting a peak of the input signal may be performed by a block unique to CFE that is not present in conventional CFR circuitry. Alternatively, the step of selecting a peak of the input signal may be performed by a modifying the existing CFR peak search block to search for peaks to expand, rather than peaks to reduce.

The CFE unit may also comprise a delay block 22 for introducing a delay into the input signal while the steps of selecting a peak of the input signal 14, generating a peak expansion impulse 18 and filtering the peak expansion signal 20 are performed such that the expanded peak can be combined in summation block 24 with the input signal to produce the crest factor expanded signal 16 for use in the amplifier pre-distortion estimation.

It should be noted that the selection of the peak for expansion may be performed in 'real time'. In other words, upon requiring a DPD estimation, the CFE unit can identify an appropriate peak in the input signal and expand that peak to the maximum power supported by the amplifier for use in the DPD estimation.

It should also be noted that the CFE method may be performed at the same sample rate as the DPD sample rate. At this sample rate, the bandwidth of the signal has been upsampled or resampled to a higher rate, so that there is the necessary bandwidth to perform the DPD estimation. This reduces the changes required to the signal to ensure that the full dynamic range of the amplifier is excited.

A peak of an input signal to be amplified may be selected and expanded periodically during each time period taken to perform amplifier digital pre-distortion estimation.

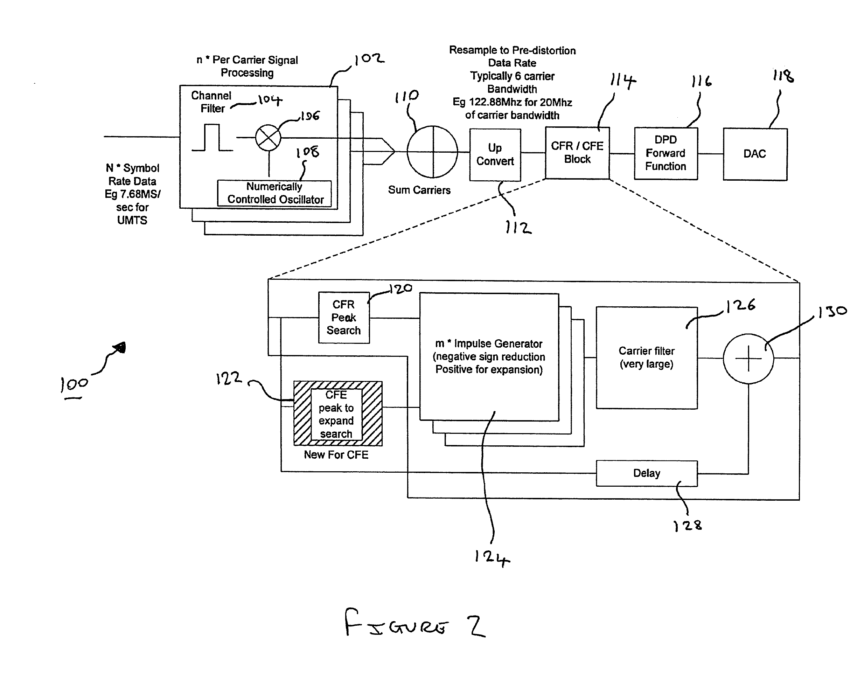

Figure 2 schematically shows a radio digital transmitter chain 100 including the CFE unit described above in relation to Figure 1. As can be seen in Figure 2, the radio digital transmitter chain 100 comprises n signal processing blocks 102 that are operable to receive n input signals (symbol rate data). Each processing block 102 generally comprises a channel filter 104, a frequency shift 106 and a numerically controlled oscillator. The outputs from the signal processors 102 are summed by a summation unit 110 before being upconverted by upconverter 112 to the DPD data rate, which may be typically six times the carrier bandwidth. The upconverted input signals are then passed to a CFR/CFE block 114 which operates in the manner described in relation to Figure 1 to select a peak of the input signal for peak expansion and expand the selected peak to the maximum power output supported by the amplifier, as will be described in further detail below. The output of the CFR/CFE block 114 is passed to the DPD estimation block 116 where DPD estimation is performed before being converted to an analogue signal in the DAC 118 to improve the linearity of the amplifier.

The CFR/CFE block 114 may be operable as both a CFR block and a CFE block. The CFR/CFE block 114 comprises a CFR peak search block 120 for use in CFR to select a peak for reduction. The CFR/CFE block 114 also comprises a CFE peak search block 122 for use in CFE to select a peak for expansion. The CFR/CFE block 114 further comprises a plurality of impulse generators 124 that are operable in both CFR and CFE, in which the impulse generators generate an inverse impulse for CFE when compared to CFR. The CFR/CFE block 114 also comprises a carrier filter 126 for use in both CFR and CFE a delay 128 and a summation unit 130.

As can be seen in Figure 2, many of the existing components that are present in a typical CFR block are utilized in CFE. The impulse generator 124 and filter 126 already exist for CFR and can be used for CFE without change. Therefore, embodiments that utilize CFE to enhance a peak to the maximum power of the amplifier require only the additional CFE peak to expand block 122 and a modification of the impulse generator 124 in order to provide the additional CFE functionality. The CFE select peak candidate for expansion 122 is similar to a CFR peak search block 120 used in CFR and therefore the CFR peak search block 120 may be reused in CFE with only small changes. This provides an efficient and cost effective mechanism improving the quality of DPD estimates based on expanded data.

It should be noted that CFE may introduce errors into the transmitted signal. However, these errors are acceptable as long as they stay within the requirements of the standards. As CFE is only required while data is being captured for DPD estimation and only one peak needs to be expanded, the effect on the EVM of the signal may be very low.

The above described embodiments improve the performance and stability of Digital Pre Distortion when the system is used in with varying transmit power. This facilitates the move to faster DPD methods that can track the amplifier better. It also helps ensure the robustness of the DPD solution by reducing the chance of amplifier damage by using DPD estimations based on data that does not have samples at the maximum power of the amplifier.

CFE is an improvement on the currently used inflation/illumination mechanism for the following reason. Firstly, inflation/Illumination has a high level of complexity and was visible to the network operator. In other words, it is not desirable to see signal added to the transmitted signal just to make the DPD estimation work. The proposed CFE method is not visible to the network operator, as although the CFE method does add a signal, this signal is added at the DPD sample rate and the duration of the added signal is therefore so small that at a system level the addition of the CFE signals is not seen.

The proposed CFE method also operates at the DPD sample rate, thereby reducing the changes required to the signal to ensure the full dynamic range of the amplifier is excited.

Smaller changes to the transmitted signal enable these CFE events to be added more often and hence support more frequency DPD estimation updates. This is an enabler for a move to faster real-time DPD. Real-time DPD enable the amplifier to be run closer to its limits and hence improve amplifier efficiency.

It should be noted that the above described embodiments may be applicable in situations in which DPD estimations from different powers are merged. Using CFE in merging DPD Solutions will further enhance the robustness of the DPD as it will act to improve the quality of some of the solutions being merged.

It should also be noted that the above described embodiments may be application in situations in which the best samples to estimate are chosen. CFE will ensure that from the pool of samples to select from, some of the samples are guaranteed to be at the maximum amplifier power. This will ensure that the pool of samples has the best possible set of samples from which to choose from, hence giving better DPD performance.

The present inventions may be embodied in other specific apparatus and/or methods. The described embodiments are to be considered in all respects as only illustrative and not restrictive. In particular, the scope of the invention is indicated by the appended claims rather than by the description and figures herein. All changes that come within the meaning and range of equivalency of the claims are to be embraced within their scope.

## Claims

1. A method for improving amplifier digital pre-distortion estimation performance, comprising the steps of:
selecting a peak of an input signal to be amplified having a signal level that is below an upper threshold signal level;
expanding the selected peak to the upper threshold signal level; and
performing amplifier pre-distortion estimation based on the expanded signal of the selected peak.

2. A method according to claim 1, wherein the step of selecting a peak of an input signal to be amplified comprises:
determining that a peak in the input signal exceeds a lower threshold signal level.

3. A method according to claim 2, wherein the step of selecting a peak of an input signal to be amplified comprises:
monitoring the input signal for a period of time.

4. A method according to claim 3, wherein the step of selecting a peak of an input signal to be amplified comprises:
selecting the first peak in the input signal in the monitored period of time that exceeds the lower threshold value.

5. A method according to claim 3 or 4, wherein the step of selecting a peak of an input signal to be amplified comprises:
reducing the lower threshold value if no peak in the input signal exceeds a lower threshold signal level in the monitored period of time.

6. A method according to claim 5, wherein the step of selecting a peak of an input signal to be amplified comprises:
monitoring the input signal for a further period of time; and
determining that a peak in the input signal exceeds the reduced lower threshold signal level.

7. A method according to any preceding claim, wherein the step of expanding the signal of the selected peak to the upper threshold signal level comprises:
generating a peak expansion signal based on the difference between the signal level of the selected peak and the upper threshold signal level.

8. A method according to claim 7, wherein the step of expanding the signal of the selected peak to the upper threshold signal level comprises:
filtering the peak expansion signal with a digital filter having a pass band matching the mask of the carrier of the signal to be amplified.

9. A method according to claim 8, wherein the step of expanding the signal of the selected peak to the upper threshold signal level comprises:
delaying the input signal while the steps of selecting a peak of an input signal to be amplified having a signal level that is below an upper threshold signal level, expanding the selected peak to the upper threshold signal level selecting and filtering the peak expansion signal are performed.

10. A method according to claim 9, wherein the step of expanding the signal of the selected peak to the upper threshold signal level comprises:
combining the filtered peak expansion signal with the delayed input signal to generate an expanded input signal for use in the amplifier pre-distortion estimation.

11. A method according to any preceding claim, wherein the upper threshold signal level is the maximum peak power supported by the amplifier.

12. A method according to any preceding claim, wherein amplifier pre-distortion estimation is performed in real time.

13. A method according to claim 12, wherein a peak of an input signal to be amplified is selected and expanded periodically during each time period taken to perform amplifier digital pre-distortion estimation.

14. A radio digital transmitter having an amplifier operable to amplify an input signal, comprising:
a crest factor expansion unit operable to select a peak of an input signal to be amplified having a signal level that is below an upper threshold signal level, and expand the selected peak to the upper threshold signal level; and
an amplifier digital pre-distortion estimation unit operable to perform amplifier pre-distortion estimation for the amplifier based on the expanded signal of the selected peak from the crest factor expansion unit.

15. A computer program product operable when executed on a computer to perform the method of any of claims 1 to 13.

## Amended claims

### Amended claims in accordance with Rule 137(2) EPC.

1. A method (10) for improving amplifier digital pre-distortion estimation performance, comprising the steps of:
selecting (14) a peak of an input signal (12) to be amplified having a signal level that is below an upper threshold signal level;
expanding (18-24) the selected peak to the upper threshold signal level;
performing amplifier pre-distortion estimation based on the expanded signal (16) of the selected peak;
wherein the upper threshold signal level is the maximum peak power supported by the amplifier.

2. A method according to claim 1, wherein the step of selecting (14) a peak of an input signal (12) to be amplified comprises:
determining that a peak in the input signal (12) exceeds a lower threshold signal level.

3. A method according to claim 2, wherein the step of selecting (14) a peak of an input signal (12) to be amplified comprises:
monitoring the input signal (12) for a period of time.

4. A method according to claim 3, wherein the step of selecting (14) a peak of an input signal (12) to be amplified comprises:
selecting the first peak in the input signal (12) in the monitored period of time that exceeds the lower threshold value.

5. A method according to claim 3 or 4, wherein the step of selecting (!4) a peak of an input signal (12) to be amplified comprises:
reducing the lower threshold value if no peak in the input signal (12) exceeds a lower threshold signal level in the monitored period of time.

6. A method according to claim 5, wherein the step of selecting (14) a peak of an input signal (12) to be amplified comprises:
monitoring the input signal (12) for a further period of time; and
determining that a peak in the input signal (12) exceeds the reduced lower threshold signal level.

7. A method according to any preceding claim, wherein the step of expanding (18-24) the signal of the selected peak to the upper threshold signal level comprises:
generating (18) a peak expansion signal based on the difference between the signal level of the selected peak and the upper threshold signal level.

8. A method according to claim 7, wherein the step of expanding (18-24) the signal of the selected peak to the upper threshold signal level comprises:
filtering (20) the peak expansion signal with a digital filter (126) having a pass band matching the mask of the carrier of the signal to be amplified.

9. A method according to claim 8, wherein the step of expanding (18-24) the signal of the selected peak to the upper threshold signal level comprises:
delaying (22) the input signal while the steps of selecting (14) a peak of an input signal to be amplified having a signal level that is below an upper threshold signal level, expanding (18-24) the selected peak to the upper threshold signal level selecting and filtering (20) the peak expansion signal are performed.

10. A method according to claim 9, wherein the step of expanding (18-24) the signal of the selected peak to the upper threshold signal level comprises:
combining (24) the filtered peak expansion signal with the delayed input signal to generate an expanded input signal (16) for use in the amplifier pre-distortion estimation.

11. A method according to any preceding claim, wherein amplifier pre-distortion estimation is performed in real time.

12. A method according to claim 11, wherein a peak of an input signal to be amplified is selected (14) and expanded (!8-24) periodically during each time period taken to perform amplifier digital pre-distortion estimation.

13. A radio digital transmitter having an amplifier operable to amplify an input signal, comprising:
a crest factor expansion unit (114, 122) operable to select a peak of an input signal to be amplified having a signal level that is below an upper threshold signal level, and expand the selected peak to the upper threshold signal level; and
an amplifier digital pre-distortion estimation unit (114, 120) operable to perform amplifier pre-distortion estimation for the amplifier based on the expanded signal of the selected peak from the crest factor expansion unit (114, 122);
wherein the upper threshold signal level is the maximum peak power supported by the amplifier.

14. A computer program product operable when executed on a computer to perform the method of any of claims 1 to 13.
